(19) Europäisches Patentamt
European Patent Office
Office européen des brevets

(11) **EP 2 365 526 A1**

(12) **EUROPEAN PATENT APPLICATION**

(43) Date of publication:
**14.09.2011 Bulletin 2011/37**

(51) Int Cl.:
***H01L 27/146*** (2006.01)

(21) Application number: **10305238.7**

(22) Date of filing: **10.03.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA ME RS**

(71) Applicants:
• **STMicroelectronics (Research & Development) Limited**
**Marlow,**
**Buckinghamshire SL7 1YL (GB)**
• **STMicroelectronics (Grenoble 2) SAS**
**38000 Grenoble (FR)**

(72) Inventors:
• **Campbell, Colin**
**Edinburgh, EH12 9JE (GB)**

• **Findlay, Ewan**
**Dollar, Clackmannanshire KY11 3HJ (GB)**
• **Le-Briz, Olivier**
**38470, Saint-Gervais (FR)**

(74) Representative: **Coret, Sophie V.G.A.**
**Cabinet Murgitroyd**
**Immeuble Atlantis**
**55 Allée Pierre Ziller**
**06560 Valbonne Sophia Antipolis (FR)**

Remarks:
A request for correction of the drawings has been filed pursuant to Rule 139 EPC. A decision on the request will be taken during the proceedings before the Examining Division (Guidelines for Examination in the EPO, A-V, 3.).

(54) **Improvements in or relating to a sensor and an imager**

(57) An imaging device including a sensor, wherein the sensor has a curved surface and is formed having a fixing member attached thereto.

Fig. 1

**Description**

Field of the invention

The present invention relates to improvements in or relating to a sensor and an imager, particularly but not exclusively for CMOS imager applications.

Background of the invention

An imager or imaging device is commonplace in many computer related applications and devices, for example, computers, phones, PDAs, cameras etc. As these devices develop, there is an increasing push to minimize the size and cost of any imaging device or camera associated with the device.

In order to minimize the size of the imaging device it is necessary to minimize all constituent elements thereof. One such element is the sensor, which can have a significant impact on the overall size of the imaging device.

The sensors may be made from silicon and processed and formed in a wafer with many sensors on a single wafer. Traditionally such a sensor is made on a relatively "thick" wafer of the order of 0.75mm. The wafer is then ground and polished to the required form and thickness. Whilst being ground and polished the wafer has to be supported. This is often achieved by means of a chuck for holding the wafer. As the wafer is ground it becomes more fragile and more susceptible to breaking and more difficult to remove from the chuck without damaging the wafer. Conventionally the wafer is removed from the chuck using a UV release membrane held on a frame which then holds the wafer during sawing. However, the removal of the thinned sawn wafer from the aforementioned membrane after UV release requires the sawn wafer to retain some degree of rigidity, which in turn implies a thickness for a given Young's modulus.

Objects of the invention

It is an object of the present invention to overcome at least some of the problems associated with the prior art.
It is a further object of the present invention to provide a sensor and a method of making the same which allows the sensor to be "thin" and not susceptible to breaking.

Summary of the invention

The present invention provides a method and system as set out in the accompanying claims.
According to one aspect of the present invention there is provided an imaging device including a sensor, wherein the sensor has a curved surface and is formed having a fixing member attached thereto.
The present invention offers a number of benefits. These include a means of forming a sensor which is much less susceptible to breaking when formed into a curved shape and during the fabrication process.

Brief description of the drawings

Reference will now be made, by way of example, to the accompanying drawings, in which:

Figure 1 is a cross-sectional diagram of an imaging device, in accordance with an embodiment of the invention,
Figure 2 is a flow diagram for illustrating the fabrication of the sensor and imaging device, in accordance with an embodiment of the invention.

Detailed description of the preferred embodiments

The present invention relates to an imaging device including a "thin" sensor, making the imaging device suitable for devices where space is a premium.
From an optical point of view a single element lens as a sensor can significantly reduce the size and cost of the imaging device. A single element lens cannot compensate for field curvature thus making parabolic and cylindrical shape a good option for sensors where space is a premium. The first order field curvature for a singlet (single element lens) is given by the formula

$$\delta z = -\frac{\phi.h}{2.n}$$

where $\phi$ is the optical power, h is the image height and n is the refractive index of the lens. If field curvature compensation is achieved by a curved sensor there is no need to balance other aberrations against the field curvature in the lens. By using a curved surface single element lens it may be possible to reduce the optical combinations to have fewer elements. For example a doublet (two lens elements) may be used to replace a triplet.

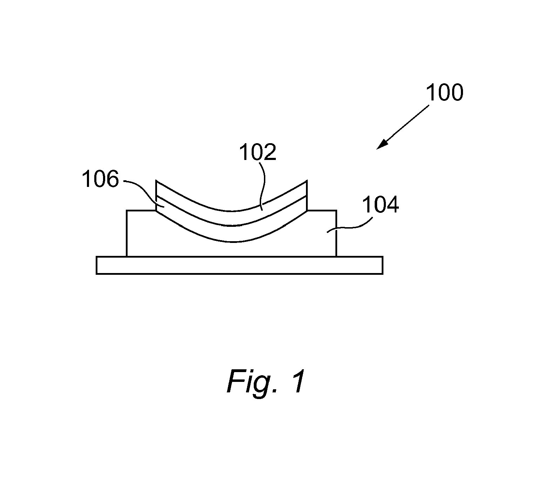

Referring to figure 1 an imaging device 100 is shown. The imaging device includes the carrier 102 and a sensor 104. The sensor is attached to the carrier by means of an adhesive layer 106. The sensor is curved as will now be described.

The sensor is made on a wafer (not shown). A typical wafer may be of the order of 0.75 mm whilst the requirement is to reduce the thickness of the sensor to be between 5 and 50 μm. This may be achieved by backgrinding the wafer to achieve the required thickness, whilst the wafer is held in a chuck. From an optical point of view the wafer needs to be thinned to the point where the surface stresses of the wafer allow a bend radius of ≤ 16 mm. This is the thickness required to allow lens compensation to occur. However, if the wafer is thinned to this point and removed from the chuck using a conventional UV release adhesive membrane it cannot in turn be removed from that membrane without the wafer being damaged.

In the present invention the conventional UV release adhesive membrane is replaced by a layer of a stiff plastics material. The stiff plastic material becomes highly pliable and adhesive upon application of heat and will thus the form to fill an underlying shape. The plastics material enables the wafer to be removed after thinning to the required thicknesses without the risk of the wafer fracturing when it is thinned below , for example 50 μm. The plastics material acts as a support for the thinned wafer. The plastics material becomes the carrier from the wafer and can be cut along with the wafer in the sawing process to yield an adhesive backed to sensor of the required deformable thickness. The plastics material also serves as a means for preventing damage to the wafer when the wafer is removed from the chuck.

The grinding process can introduce stress into the upper layers of the wafer and as a result a finishing process is often used either in conjunction with the grinding process or as a separate process.

The grinding process can be carried out by any appropriate technique including backgrinding or lapping using conventional diamond paste techniques. The finishing process may be carried out by wet or dry polishing; use of a poligrind mesh, chemical attack or plasma etching. The grinding and finishing process achieve the required thickness of the wafer and with the present embodiment deformation can occur at a later stage. Once the adhesive backed wafer of required thickness has been cut into individual sensors, the imaging device can be constructed. This is achieved by inserting a sensor into the carrier which is shaped in accordance with the required optical design of the camera in question. This may be cylindrical, spherical or aspherical in shape as required. The sensor is laid on to the carrier with the adhesive back layer in contact with the carrier. Again the adhesive layer can be made adhesive by heating or any other appropriate methodology. Appropriate connections can be made between the sensor and carrier to enable signal transfer to occur. This can be either wire-bonding, printed tracks and can use processes such as Through Silicon Via (TSV) connection methods.

In a further embodiment of the present invention the process to form the sensor may comprise the steps taking place in a different order than that described above. For example, the wafer may undergo a pre-sawing process prior to grinding and finishing. Once the wafer thinning is complete and the adhesive layer is applied a further sawing process is used to separate the individual sensors.

In a still further embodiment of the present invention the adhesive layer may be applied to the front surface of the wafer rather than the back-surface as described above. In this case the adhesive layer still acts as a support of the thin wafer, but the wafer is attached to the carrier by any other appropriate means, for example a standard adhesive layer, another adhesive layer in accordance with the present invention or any other appropriate mechanism or process. In this embodiment the adhesive layer on the front surface would need to be removed at some point so that it does not interfere with the operation of the sensor.

In an alternative embodiment of the present invention the sensor and adhesive layer may be formed in an appropriate mould before being inserted into the carrier. This can mean that the supporting structure or carrier need not be as accurately formed, which can reduce the cost of the production of the image device. This is due to the fact that the sensor and adhesive layer are formed by means of the mould for multiple sensors and then each sensor is inserted into a less accurate carrier.

As will be clear from the foregoing, the adhesive layer is one means of supporting and attaching the wafer. It will be appreciated that other fixing member and supporting means may be used instead of the adhesive layer. The functions of support and fixing may be carried out by separate elements. For example, the support may be provided by a layer on the front surface and fixing may be carried out by any appropriate adhesive or any other appropriate fixing member or mechanism.

The sensor of figure 1 has a single straight axis, a straight cylindrical axis which essentially goes into the page with reference to figure 1. This cylindrical axis is shorter than the axis of the sensor in the cross-sectional direction.

In a further embodiment (not shown), the highly pliable plastics material may be formed in the form of a double sided adhesive tape. The tape or adhesive intervening layer can be made of any appropriate material and can include die attached tapes, thermoplastic film etc. In addition, the adhesive material or intervening layer may be thermoplastic material which becomes adhesive on heating.

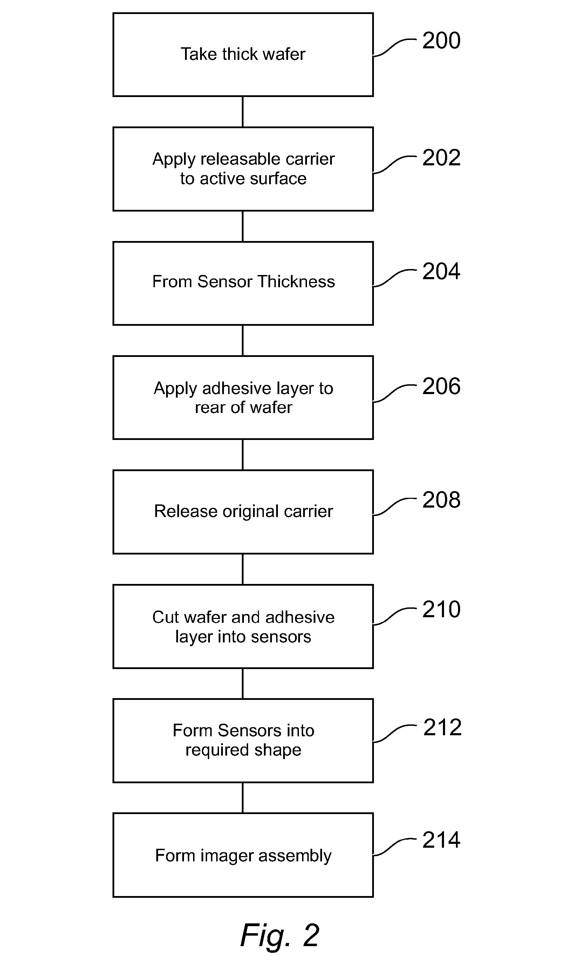

Referring to figure 2 the steps of manufacturing an imaging device or imager will now be described. First a wafer is taken in step 200 and at step 202 an adhesive layer or fixing member as described above is applied to the back surface of the wafer. The sensor is formed into the required thickness at the step 204 by means of any appropriate processing methods, for example grinding and finishing. In the embodiments which include an adhesive layer, a step 206 is carried out to attach the adhesive layer to either the back or rear of the wafer depending on which embodiment applies. After the adhesive layer is applied the wafer is released from the carrier in step 208. The wafer is then cut into individual sensors at step 210. The sensor is then formed into the required shape either by means of insertion into the carrier or into an appropriate mould at step 212. At step 214 the final imaging device is formed by means of connecting appropriate connections where required.

It will be appreciated that the above mentioned steps may be carried out in a different order and/or augmented to add pre-sawing and attachment of a different fixing member or fixing means as is described above with reference to the different embodiments.

The image or imaging device can then be used in any appropriate device which incorporates a camera.

The suitable devices may include a mobile or smart telephone, other personal or communications devices, a camera or any other suitable device.

The present invention may include many variations which do not change the scope of the invention. The description includes some examples but any reasonable equivalents are included by implication.

**Claims**

1.  An imaging device including a sensor, wherein the sensor has a curved surface and is formed having a fixing member attached thereto.

2.  The imaging device of claim 1, wherein the fixing member is an adhesive layer attached to the sensor.

3.  The imaging device of claim 2, wherein the adhesive layer forms a support whilst the sensor is processed from a wafer.

4.  The imaging device of claim 2 or claim3, wherein the adhesive layer includes adhesive on both sides.

5.  The imaging device of any of claims 1 to 4, wherein the fixing member is formed from a pliable thermoplastics material.

6.  The imaging device of any preceding claim, wherein the sensor is ground to a thickness of less than 0.18 mm.

7.  The imaging device of any preceding claim, wherein the sensor is ground to a thickness of less than 50 $\mu$m.

8.  The imaging device of any preceding claim, wherein the sensor is attached to a carrier in order to form the imaging device.

9.  The imaging device of any preceding claim, wherein the sensor is curved to have a minimum bend radius of less than 16 mm.

10. A device including an imaging device according to any preceding claim.

11. The device of claim 10 in the form of a camera.

12. The device of claim 10 in the form of a phone.

13. The device of claim 10 in the form of a computer.

14. A sensor for an imaging device having a curved surface and including a fixing member.

15. The sensor of claim 15, wherein the fixing member is an adhesive layer.

16. The sensor of claim 15, wherein the adhesive layer is attached before the sensor is processed from a wafer.

17. A method of forming a sensor for an imaging device, comprising the steps of:

- applying a fixing member to a wafer for forming a plurality of sensors;
- processing the wafer to achieve a predetermined thickness thereof;
- cutting the wafer into individual sensors; and
- bending the sensor and the fixing member into a required curved form.

Fig. 1

| Take thick wafer | 200 |
| Apply releasable carrier to active surface | 202 |
| From Sensor Thickness | 204 |
| Apply adhesive layer to rear of wafer | 206 |
| Release original carrier | 208 |
| Cut wafer and adhesive layer into sensors | 210 |
| Form Sensors into required shape | 212 |
| Form imager assembly | 214 |

*Fig. 2*

Europäisches
Patentamt
European
Patent Office
Office européen
des brevets

**EUROPEAN SEARCH REPORT**

Application Number

EP 10 30 5238

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/115875 A1 (CHOI MIN-SEOG [KR] ET AL) 7 May 2009 (2009-05-07) * paragraphs [0047] - [0050], [0055] - [0057], [0069]; figures 1,2A-2E * ----- | 1-17 | INV. H01L27/146 |
| X | US 2007/228502 A1 (MINAMIO MASANORI [JP] ET AL) 4 October 2007 (2007-10-04) * paragraphs [0077] - [0085], [0103] - [0108]; figures 5B,9A-9D * ----- | 1-3,5-8, 10-15 | |
| X | EP 2 063 629 A1 (PANASONIC CORP [JP]) 27 May 2009 (2009-05-27) * paragraph [0044] - paragraph [0068]; figures 4b,5b * ----- | 1-3,5,8, 10-15 | |
| X | US 2006/186492 A1 (BOETTIGER ULRICH C [US] ET AL) 24 August 2006 (2006-08-24) * paragraphs [0046], [0051] - [0057]; figures 12A-12B.13A-13D * ----- | 1-3,5,8, 10-15 | |

|  |
|---|
| TECHNICAL FIELDS SEARCHED (IPC) |
| H01L |

The present search report has been drawn up for all claims

| Place of search | Date of completion of the search | Examiner |
|---|---|---|
| The Hague | 16 August 2010 | Franche, Vincent |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.**                         EP 10 30 5238

This annex lists the patent family members relating to the patent documents cited in the above-mentioned European search report.
The members are as contained in the European Patent Office EDP file on
The European Patent Office is in no way liable for these particulars which are merely given for the purpose of information.

16-08-2010

| Patent document cited in search report | | Publication date | Patent family member(s) | | Publication date |
|---|---|---|---|---|---|
| US 2009115875 | A1 | 07-05-2009 | KR | 20090044901 A | 07-05-2009 |
| US 2007228502 | A1 | 04-10-2007 | CN | 101047195 A | 03-10-2007 |
| | | | JP | 2007266380 A | 11-10-2007 |
| EP 2063629 | A1 | 27-05-2009 | CN | 101536488 A | 16-09-2009 |
| | | | JP | 2008092532 A | 17-04-2008 |
| | | | WO | 2008041739 A1 | 10-04-2008 |
| | | | US | 2010025789 A1 | 04-02-2010 |
| US 2006186492 | A1 | 24-08-2006 | US | 2007096235 A1 | 03-05-2007 |
| | | | US | 2007120212 A1 | 31-05-2007 |

EPO FORM P0459

For more details about this annex : see Official Journal of the European Patent Office, No. 12/82